# FASCICULE DE BREVET EUROPEEN

(11) **EP 2 150 979 B1**
(45) Date de publication et mention de la délivrance du brevet: **12.01.2011**
(21) Numéro de dépôt: 08759913.0
(22) Date de dépôt: 22.05.2008
(51) Int. Cl.: H01L 27/146

(54) **PROCEDE DE REALISATION D'UN DETECTEUR DE RAYONNEMENT**
VERFAHREN ZUR HERSTELLUNG EINES STRAHLUNGSDETEKTORS
METHOD OF PRODUCING A RADIATION DETECTOR

(30) Priorité: 23.05.2007 FR 0755204
(43) Date de publication de la demande: 10.02.2010
(73) Titulaire: Trixell S.A.S., 38430 Moirans (FR)
(72) Inventeur: VIEUX, Gérard, F-38190 Froges (FR); VIGNOLLE, Jean-Michel, F-38430 St Jean de Moirans (FR); ROHR, Pierre, F-38140 Apprieu (FR); COUDER, David, F-38000 Grenoble (FR); DUBOIS, Sébastien, F-67380 Lingolsheim (FR)
(74) Mandataire: Collet, Alain
(86) Numéro de dépôt international: PCT/EP2008/056312
(87) Numéro de publication internationale: WO 2008/142135

(56) Documents cités:
- EP-A- 0 766 317
- FR-A- 2 758 654
- JP-A- 9 257 943
- US-A- 5 990 505

## Description

La présente invention concerne un procédé de réalisation d'un détecteur de rayonnement comportant un capteur photosensible associé à un convertisseur de rayonnement. Les domaines d'application de ce type de détecteur sont notamment la détection de rayonnements X utilisés en radiologie : radiographie, fluoroscopie, mammographie, et également pour le contrôle non destructif. L'invention sera décrite en rapport avec un détecteur de rayonnement X. Il est bien entendu que l'invention peut être mise en oeuvre dans tout type de détecteur pour lequel le capteur photosensible n'est pas directement sensible au rayonnement à détecter, et pour lequel il est donc nécessaire d'interposer un convertisseur de rayonnement entre une fenêtre d'entrée du détecteur et le capteur photosensible.

De tels détecteurs de rayonnement sont connus par exemple par le brevet français FR 2 605 166 dans lequel un capteur formé de photodiodes en silicium amorphe est associé à un convertisseur de rayonnement. Le document JP-A-09 257943 décrit un procédé de réalisation d'un capteur d'image.

Le fonctionnement et la structure d'un tel détecteur de rayonnement vont être rappelés succinctement.

Le capteur photosensible est généralement réalisé à partir d'éléments photosensibles à l'état solide arrangés en matrice. Les éléments photosensibles sont réalisés à partir de matériaux semi-conducteurs, le plus souvent du silicium mono cristallin pour les capteurs de type CCD ou CMOS, du silicium poly cristallin ou amorphe. Un élément photosensible comporte au moins une photodiode, un phototransistor ou une photo résistance. Ces éléments sont déposés sur un substrat, généralement une dalle de verre.

Ces éléments ne sont généralement pas sensibles directement aux rayonnements de longueurs d'ondes très courtes comme le sont les rayons X ou gamma. C'est pourquoi, on associe le capteur photosensible à un convertisseur de rayonnement qui comporte une couche d'une substance scintillatrice. Cette substance a la propriété, lorsqu'elle est excitée par de tels rayonnements, d'émettre un rayonnement de longueur d'onde supérieure, par exemple de la lumière visible ou proche du visible, auquel est sensible le capteur. La lumière émise par le convertisseur de rayonnement illumine les éléments photosensibles du capteur qui effectuent une conversion photoélectrique et délivrent des signaux électriques exploitables par des circuits appropriés. Le convertisseur de rayonnement sera appelé scintillateur dans la suite de la description.

Certaines substances scintillatrices de la famille des halogénures alcalins ou des oxysulfures de terres rares sont fréquemment employées pour leurs bonnes performances.

Parmi les halogénures alcalins, l'iodure de césium dopé au sodium ou au thallium selon que l'on souhaite une émission vers 400 nanomètres ou vers 550 nanomètres respectivement, est connu pour sa forte absorption des rayons X et pour son excellent rendement de fluorescence. Il se présente sous la forme de fines aiguilles que l'on fait croître sur un support. Ces aiguilles sont sensiblement perpendiculaires à ce support et elles confinent en partie la lumière émise vers le capteur. Leur finesse conditionne la résolution du détecteur. Les oxysulfures de lanthane et de gadolinium sont aussi très employés pour les mêmes raisons.

Mais parmi ces substances scintillatrices, certaines ont comme inconvénient d'être peu stables, elles se décomposent partiellement lorsqu'elles sont exposées à l'humidité et leur décomposition libère des espèces chimiques qui migrent soit vers le capteur soit à l'opposé du capteur. Ces espèces sont très corrosives. L'iodure de césium et l'oxysulfure de lanthane ont notamment cet inconvénient.

En ce qui concerne l'iodure de césium, sa décomposition donne de l'hydroxyde de césium Cs+ OH- et de l'iode libre I₂ qui peut ensuite se combiner avec des ions iodures pour donner le complexe I₃.

En ce qui concerne l'oxysulfure de lanthane sa décomposition donne du sulfure d'hydrogène H₂S chimiquement très agressif.

L'humidité est extrêmement difficile à supprimer. L'air ambiant, sous lequel l'opération de scellement est réalisée, en contient toujours.

L'un des aspects importants lors de la réalisation de ces détecteurs sera de minimiser la quantité d'humidité présente initialement à l'intérieur du détecteur, et en contact avec le scintillateur, et d'éviter la diffusion de cette humidité à l'intérieur du capteur lors de son fonctionnement.

Dans une première configuration, dite du scintillateur rapporté, la substance scintillatrice est déposée sur un support que le rayonnement à détecter doit traverser avant d'atteindre le capteur. L'ensemble est alors collé sur le capteur.

Dans une seconde configuration, dite du dépôt direct, le capteur sert de support à la substance scintillatrice qui est alors en contact direct et intime avec le capteur. La substance scintillatrice est ensuite recouverte d'une feuille de protection. Les deux configurations présentent chacune des avantages et des inconvénients.

Un avantage de la première configuration, dite du scintillateur rapporté, est que le capteur et le scintillateur ne sont assemblés que s'ils ont été testés avec succès ce qui permet d'améliorer le rendement global de fabrication.

D'autres avantages de cette configuration apparaîtront à la lecture de la demande de brevet français FR 2 831 671.

L'invention cherche à améliorer la fabrication d'un détecteur de grande dimension nécessitant le raboutage de plusieurs capteurs photosensibles de plus petites dimensions, le détecteur de rayonnement étant réalisé selon la première configuration comme décrit dans la revendication 1.

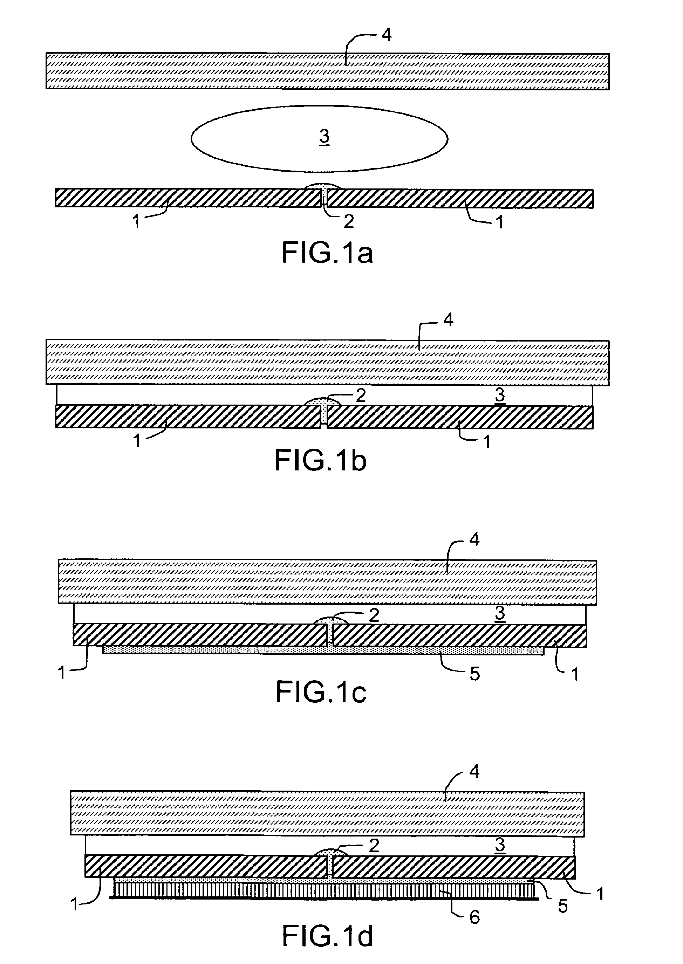

Les figures 1a à 1d décrivent un mode opératoire permettant la réalisation des ensembles raboutés.

Des capteurs 1 de petites dimensions sont alignés et positionnés individuellement. Un joint d'étanchéité 2 est positionné entre les capteurs 1.

Un adhésif liquide 3 est ensuite répandu sur les capteurs 1. Le joint d'étanchéité 2 permet d'éviter le fluage de l'adhésif 3 entre les capteurs 1. Un substrat 4 commun aux différents capteurs 1 est ensuite collé sur les capteurs 1 au moyen de l'adhésif 3. Le matériau du joint d'étanchéité 2 doit être de haute viscosité afin d'éviter de fluer lui-même entre les capteurs 1. Cette viscosité doit cependant être suffisamment basse afin d'épouser parfaitement une partie de l'espace que l'adhésif 2 doit remplir entre les capteurs 1.

Le matériau de l'adhésif 3 doit, quant à lui, être de viscosité suffisamment basse pour migrer sur l'intégralité des surfaces des capteurs 1 afin de réaliser un collage sur l'intégralité de la surface. Par conte, un adhésif 3 trop fluide aura tendance à déborder en périphérie des capteurs 1.

Avec ce mode opératoire, il est impossible de mettre en oeuvre un adhésif unique tenant lieu à la fois d'adhésif 2 et d'adhésif 3. Cet adhésif unique devrait faire face à la contradiction d'être à la fois suffisamment fluide pour migrer sur l'intégralité des surfaces des capteurs 1 et réaliser un collage total, et suffisamment visqueux afin d'éviter de fluer entre les capteurs 1.

L'opération suivante dans le mode de réalisation d'un détecteur de rayonnement consiste à déposer sur l'ensemble rabouté ainsi réalisé une couche d'adhésif liquide 5 destiné à coller un scintillateur 6 sur l'ensemble rabouté. L'adhésif 5 est un matériau qui doit être transparent optiquement afin de ne pas absorber la lumière émise par le scintillateur 6 éclairé par un rayonnement X. Le matériau de l'adhésif 5 doit être de viscosité suffisamment basse afin de pénétrer entre les capteurs 1 et de combler totalement l'espace résiduel entre les capteurs 1 laissé libre par l'adhésif 2 déposé lors de l'opération précédente. Il doit également être de viscosité suffisamment élevée afin de ne pas fluer de manière excédentaire sur la périphérie des capteurs 1.

L'adhésif 5 doit être suffisamment mince pour permettre une bonne qualité d'image. En effet, la lumière générée par le scintillateur 6 doit traverser cette couche de colle avant d'être absorbée par les capteurs 1. La dispersion de cette lumière sera d'autant plus faible que l'épaisseur de l'adhésif 5 sera mince.

On a par exemple mis en oeuvre des adhésifs liquides 5 issus des familles des adhésifs silicones, époxy, acryliques ou toute autre famille. Ces adhésifs liquides doivent être préalablement déposés sur l'une des deux surfaces à coller ou sur les deux. Cette dispense de colle doit être très homogène en épaisseur, et cette épaisseur parfaitement contrôlée afin de permettre une qualité d'image, et notamment de résolution, homogène en tous points de cette image.

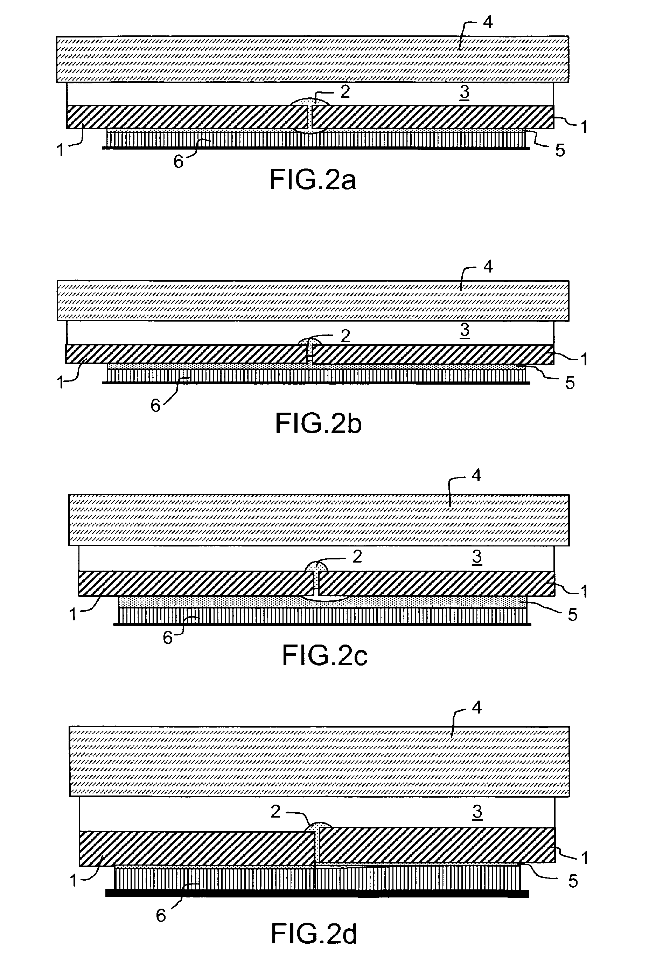

Les figures 2a à 2d décrivent 4 types de défauts rencontrés lors de la réalisation des détecteurs. Ces défauts de réalisation se traduisent par des défauts dans l'image produite par le détecteur sous insolation de rayonnement X.

Sur la figure 2a, le premier défaut est caractéristique d'une viscosité trop faible pour l'adhésif 2 qui s'immisce complètement dans l'espace disponible entre les capteurs 1 et vient en contact directement avec le scintillateur 6 quand celui-ci sera collé au moyen de l'adhésif 5. Ce premier défaut de réalisation se traduit par un défaut sur l'image obtenue par le détecteur. La quantité de lumière atteignant les capteurs 1 sera trop importante à la jonction entre les capteurs 1. La sensibilité du détecteur en ces lieux sera trop importante

Sur la figure 2b, le deuxième défaut est caractéristique, soit d'une viscosité trop élevée pour l'adhésif 2, soit d'une viscosité trop élevée pour l'adhésif 5. Ces deux adhésifs ne peuvent pas venir en contact l'un de l'autre et une cavité pleine d'air persiste entre les capteurs 1. Cela peut se traduire par une rupture de la continuité optique des trajets lumineux aux interfaces lorsque la lumière issue du scintillateur 6 va les traverser. Il va s'ensuivre une perte de lumière, et une image trop sombre à l'endroit de ces cavités pleines d'air.

Ce type de défaut peut évoluer et créer le troisième défaut, représenté sur la figure 2c dans laquelle le volume d'air piégé peut être expansé et créer des décollements des interfaces collées.

Le quatrième défaut représenté sur la figure 2d peut s'observer lorsque les capteurs 1 ne sont pas correctement alignés dans le plan horizontal, et qu'il y a ainsi un défaut d'altimétrie. Une marche mécanique lors du passage d'un capteur 1 à son voisin peut se traduire par une rupture dans la continuité de l'adhésif 5. Ce type de défaut pourrait être résolu par un adhésif 5 dont la viscosité serait suffisamment basse pour épouser la rupture de marche mécanique. Par contre, une viscosité trop basse de l'adhésif 5 peut se traduire par une mauvaise pérénité du contact optique à la rupture de marche.

Ainsi, les quatre défauts de réalisation décrits plus haut se traduisent toujours par des ruptures dans la continuité de l'adhésif 5, et des absences de matière ou cavités d'air qui se traduiront par des défauts de couplage optique du scintillateur 6. A l'endroit de ces défauts, l'image pourra être exagérément blanche (premier défaut) ou noire (deuxième à quatrième défauts).

La résolution de ces défauts est confrontée à la viscosité des adhésifs 2, 3 et 5 qui nécessiteraient des propriétés contradictoires. Il est en effet demandé aux adhésifs 2, 3 et 5, d'être de viscosités suffisamment basses ou suffisamment élevées pour remplir des fonctions contradictoires.

L'invention vise à pallier tout ou partie des problèmes cités plus haut en proposant un procédé de réalisation d'un détecteur de rayonnement comportant plusieurs capteurs raboutés sans joint d'étanchéité spécifique entre les capteurs.

A cet effet, l'invention a pour objet un procédé de réalisation d'un détecteur de rayonnement comportant un ensemble capteur photosensible, un scintillateur transformant le rayonnement en un rayonnement auquel l'ensemble capteur photosensible est sensible, le scintillateur étant fixé par collage sur l'ensemble capteur, l'ensemble capteur comportant un substrat et plusieurs capteurs raboutés, les capteurs comportant chacun deux faces oposées dont une première est collée sur le substrat et dont une seconde est collée sur le scintillateur, caractérisé en ce qu'on enchaîne les opérations suivantes :
- déposer les capteurs par leur seconde face sur un film adhésif ;
- coller les capteurs par leur première face sur le substrat.

L'invention sera mieux comprise et d'autres avantages apparaîtront à la lecture de la description détaillée de modes de réalisation donnés à titre d'exemple, description illustrée par le dessin joint dans lequel :
les figures 1a à 1d représentent un procédé connu de réalisation d'un détecteur de rayonnement ;
les figures 2a à 2d représentent plusieurs défauts liés au procédé décrit à l'aide des figures 1 a à 1 d ;
les figures 3a à 3d représentent une première variante de mise en oeuvre du procédé de l'invention ;
les figures 4a à 4c représentent une deuxième variante de mise en oeuvre du procédé de l'invention ;
les figures 5a à 5c représentent une troisième variante de mise en oeuvre du procédé de l'invention ;
les figures 6a à 6d représentent une quatrième variante de mise en oeuvre du procédé de l'invention.

Par souci de clarté, les mêmes éléments porteront les mêmes repères dans les différentes figures.
Les figures 1 a à 1 d et les figures 2a à 2d ont déjà été décrites plus haut.

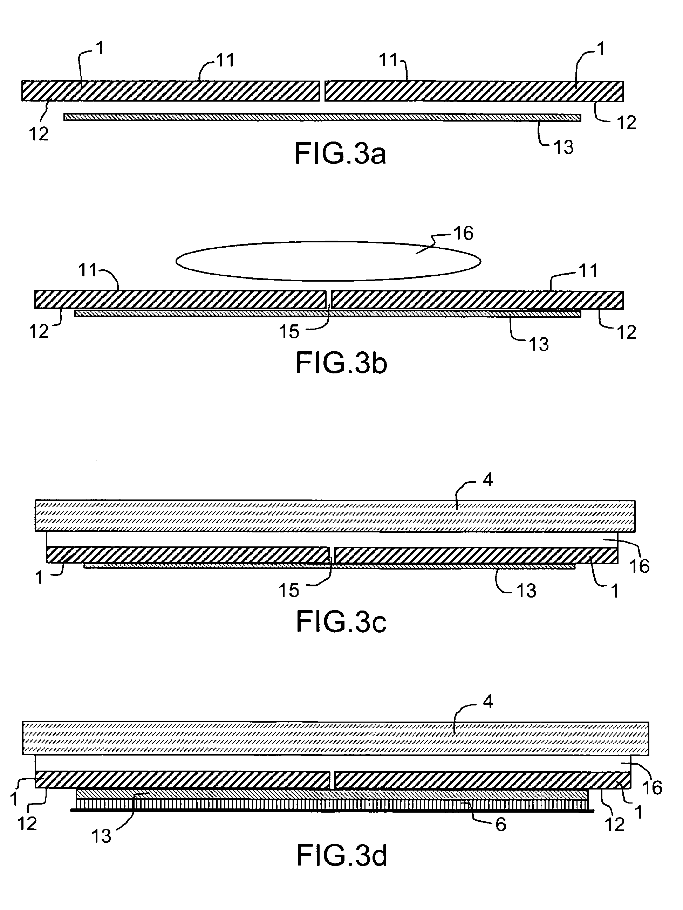

La figure 3a représente une première étape de réalisation d'un détecteur de rayonnement comportant plusieurs capteurs 1 photosensibles comportant avantageusement une matrice de photodiodes ou de phototransistors de type TFT réalisés sur une dalle de silicium amorphe. La figure 3a ne représente que deux capteurs 1 mais il est bien entendu que l'invention peut être mise en oeuvre pour un plus grand nombre de capteurs 1 raboutés. Les capteurs 1 comportent tous deux, deux faces oposées 11 et 12. Une première étape d'un procédé conforme à l'invention consiste à déposer les capteurs 1 par leur face 12 sur un film adhésif 13. Le film adhésif 13 est utilisé comme plan de référence lors de la dépose et du collage des capteurs 1 sur celui-ci. Ceci permet d'améliorer l'alignement des faces 12 des différents capteurs 1.

Une seconde étape du procédé consiste à coller les capteurs 1 par leur face 11 sur un substrat 4. Cette étape est illustrée à l'aide des figures 3b et 3c. Dans un premier temps de cette seconde étape, on dépose sur la face 11 des capteurs 1 et dans des interstices 15 séparant les capteurs 1 un adhésif liquide 16. On choisit un adhésif 16 de faible viscosité afin de remplir tout l'espace laissé à sa disposition, notamment les interstices 15. Dans un second temps, on colle les capteurs 1 et le substrat 4 au moyen de l'adhésif liquide 16. Le film 13 empêche l'adhésif liquide 16 de fluer par les interstices 15. L'utilisation du film adhésif 13 comme plan de référence permet également un bon remplissage de l'espace entre les capteurs 1 et le substrat 4 par la colle 16. Le film adhésif 13 assure notamment une bonne étanchéité des interstices 15 pour y contenir la colle liquide 16 et surtout éviter que la colle liquide 16 ne puisse se glisser entre le film adhésif 13 et les capteurs 1 au niveau de la face 11. Il n'est plus besoin de mettre en oeuvre un joint d'étanchéité 2 tel que décrit à l'aide des figures 1 a à 1 d.

Le bon remplissage de cet espace est nécessaire pour obtenir un collage optique spatialement continu et homogène entre capteurs 1 et substrat 4. Ce remplissage est nécessaire au bon fonctionnement de détecteurs nécessitant un éclaraige spatialement continu et homogène au travers du substrat 4, éclairage non représenté.

Une troisième étape du procédé, illustrée à l'aide de la figure 3d, consiste à coller un scintillateur 6 sur la face 12 des capteurs 1 au moyen du film adhésif 13.

Dans la première étape du procédé, les capteurs 1 sont alignés et déposés sur le film adhésif 13 sous vide ou par laminage afin d'éviter le piégeage de bulles d'air entre le film adhésif 13 et les capteurs 1. Le film adhésif 13 par sa nature continue et d'épaisseur constante va assurer une surface parfaitement plane après réalisation de l'ensemble rabouté, et va présenter cette surface plane et exempte de défauts pour le collage optique du scintillateur 6.

Le fait de réaliser la première étape avant la seconde permet d'assurer une bonne planéité entre les faces 12 des différents capteurs 1.

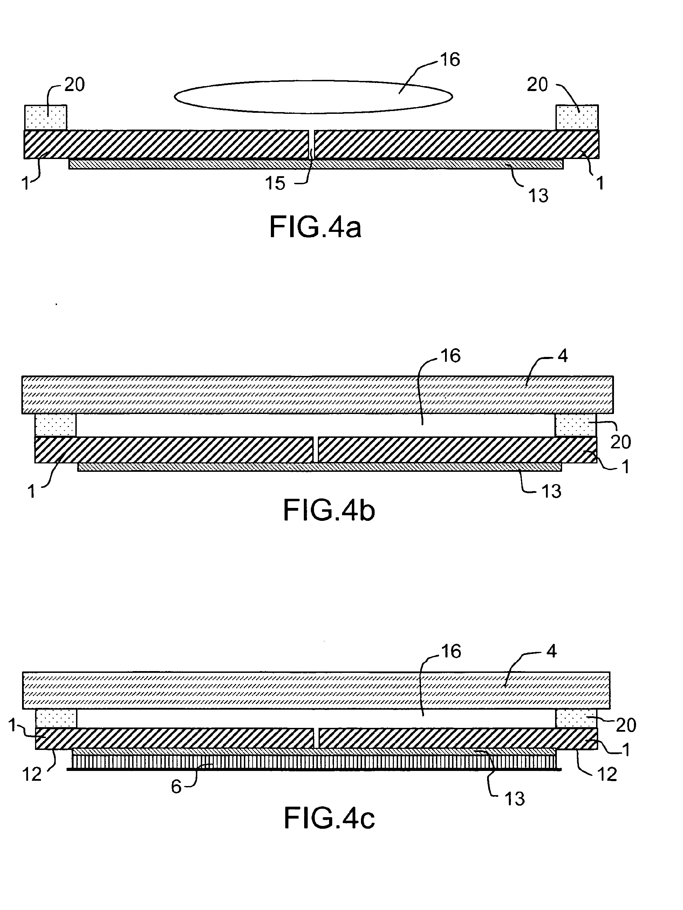

Une variante de la deuxième étape, illustrée à l'aide des figures 4a à 4c, consiste à placer en périphérie des capteurs 1 un anneau 20 permettant de retenir l'adhésif liquide 16. Grâce à cet anneau 20, on peut mettre en oeuvre un adhésif 16 à très faible viscosité afin de s'assurer d'un bon remplissage des interstices 15 en évitant d'éventuels débordements de l'adhésif 16 en périphérie des capteurs 1. Outre la rétention de l'adhésif 16 en périphérie des capteurs 1, l'anneau 20 peut également assurer la rigidité d'un ensemble formé par les capteurs 1 et le film adhésif 13.

La figure 4a illustre le premier temps de la seconde étape, pendant lequel on dépose l'adhésif liquide 16. La figure 4b illustre le second temps pendant lequel on colle les capteurs 1 et le substrat 4. La figure 4c illustre la troisième étape du procédé pendant laquelle on colle le scintillateur 6 sur la face 12 des capteurs 1 au moyen du film adhésif 13.

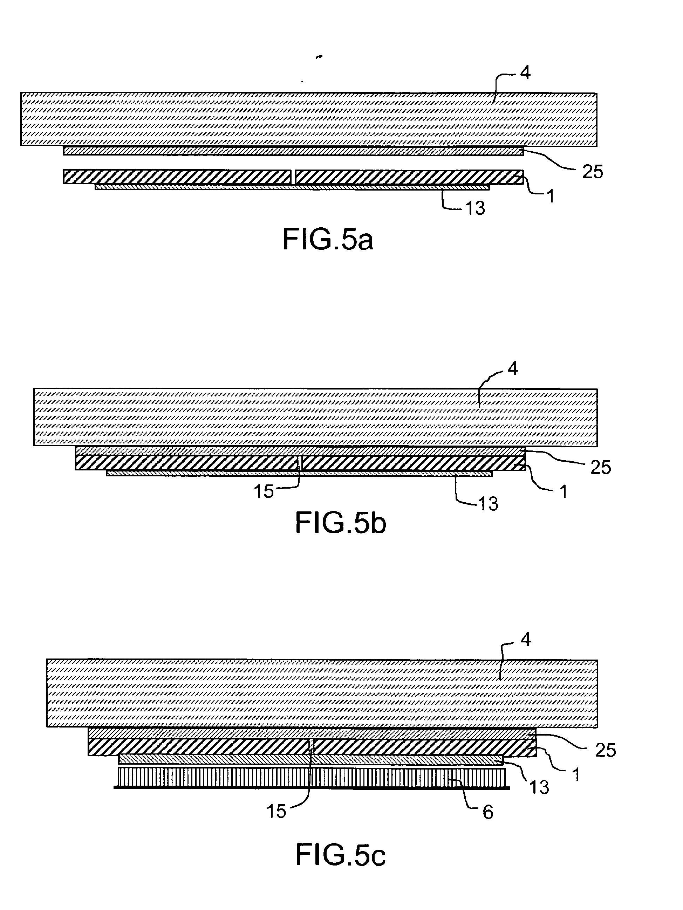

Les figure 5a à 5c illustrent une variante du procédé de l'invention dans laquelle on remplace l'adhésif liquide 16 par un second film adhésif 25 pour coller les capteurs 1 au substrat 4. Sur la figure 5a, le film adhésif 25 est déposé sur le substrat 4. Sur la figure 5b, l'ensemble formé par les capteurs 1 et le film 13 est collé sur le substrat 4 et sur la figure 5c, le scintillateur 6 est collé sur la face 12 des capteurs 1 au moyen du film adhésif 13.

Dans cette variante de réalisation, on peut prévoir de remplir les interstices 15 au moyen d'un adhésif liquide à très faible viscosité pour assurer une bonne continuité optique entre le scintillateur 6 et les différents capteurs 1.

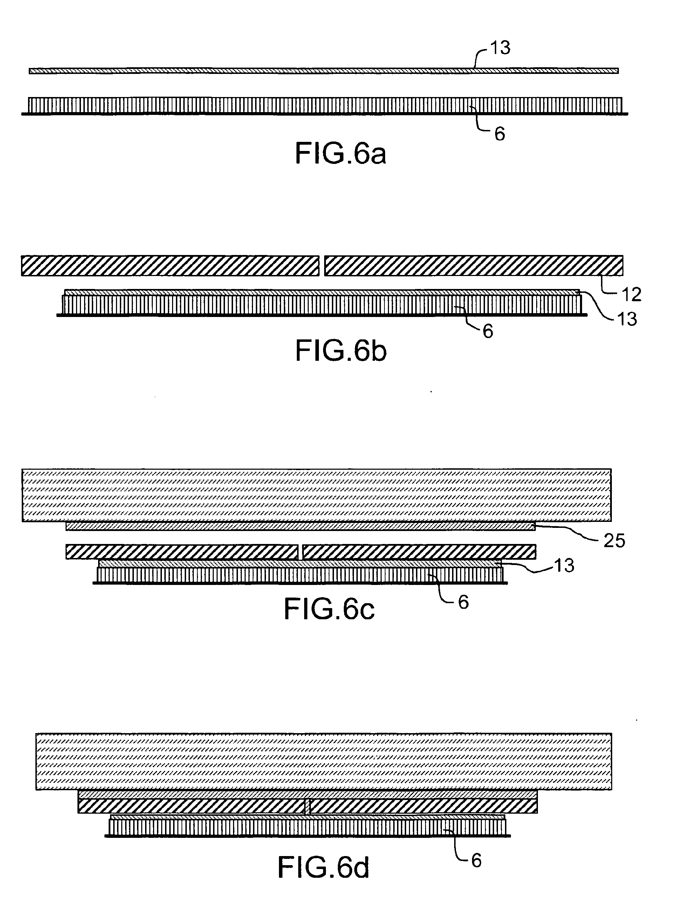

Les figure 6a à 6d illustrent une autre variante du procédé de l'invention dans laquelle le collage du scintillateur 6 sur la seconde face 12 des capteurs 1 au moyen du film adhésif 13 intervient avant le collage des capteurs 1 sur le substrat 4.

Sur la figure 6a, le film adhésif 13 est déposé sur le scintillateur 6. Sur la figure 6b, les capteurs 1 sont collés sur le scintillateur 6 au moyen du film 13. Sur la figure 6c, l'ensemble formé par les capteurs 1 et le scintillateur 6 est collé sur le substrat 4 au moyen du film adhésif 25 et sur la figure 6d les interstices 15 sont remplis au moyen d'un adhésif liquide à très faible viscosité.

Il est bien entendu possible de remplacer le collage des capteurs 1 réalisés à l'aide du film 25 par un collage réalisé à l'aide de l'adhésif 16 comme décrits dans les figure 3 ou 4.

Les films adhésifs 13 et 25 peuvent être des masses adhésives brutes transparentes disponibles entre deux opercules pelable de protection. Ce peut être des films transparents revêtus sur leurs deux faces de couches adhésives, protégées elles aussi par des opercules de protection. Ce peut également être des films thermofusibles dont l'adhérence est développées par un traitement thermique, tel que décrit plus bas.

Avantageusement, les films adhésifs 13 et 25 sont dépourvus d'adhérence à température ambiante. Cela permet de faciliter le positionnement du scintillateur 6 et du substrat 4 par rapport aux capteurs 1 avant la mise en oeuvre du collage effectif à l'aide des films adhésifs 13 et 25. L'absence d'adhérence à température ambiante présente un autre avantage dans le cas d'un scintillateur comportant de l'oxysulfure de gadolinium. En effet, la structure en aiguilles des scintillateurs à base d'iodure de césium permet l'évacuation de l'air emprisonné entre les capteurs 1 et le scintillateur 6 lors de leur rapprochement. Par contre, les scintillateurs réalisés à base d'oxysulfure de gadolinium utilisent un liant de type plastique leur conférant une surface lisse qui ne permet pas l'évacuation de l'air emprisonné entre les capteurs 1 et le scintillateur 6 comme dans le cas d'une structure en aiguille. L'absence d'adhérence permet en conséquence d'évacuer l'air emprisonné entre les capteurs 1 et le scintillateur 6 lors du positionnement du scintillateur 6 par rapport aux capteurs 1 avant la mise en oeuvre du collage effectif à l'aide du film adhésif 13.

Avantageusement, le film adhésif 13 est thermofusible. Autrement dit, la mise en oeuvre du collage au moyen du film adhésif 13 se fait en augmentant la température de l'ensemble formé par le capteur 1, le film adhésif 13 et le scintillateur 5 une fois positionnés entre eux.

Avantageusement, le film adhésif 13 comporte du polyéthylène ou du polypropylène ou du polyuréthane ou du polyamide ou du polyvinylbutyral ou de l'éthylène-vinyl acétate.

Avantageusement le film adhésif 13 a une épaisseur comprise entre 20 et 40µm. Cette épaisseur est inférieure à ce qui est possible de réaliser avec des moyens de mise en oeuvre d'une colle optique connue disponible sous forme liquide ou de gel. On utilise par exemple la sérigraphie pour déposer la colle de façon la plus homogène possible. Ce moyen de mise en oeuvre ne permet pas en pratique d'obtenir une couche de colle homogène d'épaisseur inférieure à 40µm qui puisse permettre de remplir la fonction de couplage optique du scintillateur. En revanche, on peut obtenir des films adhésifs d'épaisseur parfaitement contrôlée égale à 25 µm par laminage.

## Revendications

1. Procédé de réalisation d'un détecteur de rayonnement comportant un ensemble capteur (1, 4) photosensible, un scintillateur (6) transformant le rayonnement en un rayonnement auquel l'ensemble capteur photosensible est sensible, le scintillateur (6) étant fixé par collage sur l'ensemble capteur (1, 4), l'ensemble capteur comportant un substrat (4) et plusieurs capteurs (1) raboutés, les capteurs (1) comportant chacun deux faces oposées (11, 12) dont une première (11) est collée sur le substrat (4) et dont une seconde (12) est collée sur le scintillateur (6), **caractérisé en ce qu'**on enchaîne dans l'ordre les opérations suivantes :
• déposer les capteurs (1) par leur seconde face (12) sur un film adhésif (13) ;
• coller les capteurs (1) par leur première face (11) sur le substrat (4)
• coller le scintillateur (6) au moyen du film adhésif (13),
et **en ce que** le film adhésif (13) est utilisé comme plan de référence lors du collage des capteurs (1) sur le film adhésif.

2. Procédé selon la revendication 1, **caractérisé en ce que** l'opération de collage des capteurs (1) sur le substrat (4) comprend les opérations suivantes :
• déposer sur la première face (11) des capteurs (1) et dans des interstices (15) séparant les capteurs (1) un adhésif liquide (16) ;
• coller les capteurs (1) et le substrat (4) au moyen de l'adhésif liquide (16).

3. Procédé selon la revendication 2, **caractérisé en ce qu'**avant de déposer l'adhésif liquide (16), on place en périphérie des capteurs (1) un anneau (20) permettant de retenir l'adhésif liquide (16).

4. Procédé selon la revendication 1, **caractérisé en ce que** l'opération de collage des capteurs (1) sur le substrat (4) comprend les opérations suivantes :
• déposer sur la première face (11) des capteurs un second film adhésif (25) ;
• coller les capteurs (1) et le substrat (4) au moyen du second film adhésif (25).

5. Procédé selon la revendications 4, **caractérisé en ce qu'**on remplit des interstices (15) séparant les capteurs (1) au moyen d'un adhésif liquide.

6. Procédé selon l'une des revendications précédentes, **caractérisé en ce que** les capteurs (1) photosensibles comportent une matrice de photodiodes ou de phototransistors de type TFT réalisées sur une dalle de silicium amorphe.

7. Procédé selon l'une des revendications précédentes, **caractérisé en ce que** les capteurs (1) sont réalisés dans une technologie CMOS.

8. Procédé selon l'une des revendications précédentes, **caractérisé en ce que** le scintillateur (6) est réalisé à base d'oxysulfure de gadolinium.

9. Procédé selon l'une quelconque des revendications 1 à 7, **caractérisé en ce que** le scintillateur (6) est réalisé à base d'iodure de césium.

10. Procédé selon l'une des revendications précédentes, **caractérisé en ce que** le film adhésif (13, 25) comporte un matériau compris dans un groupe comprenant du polyéthylène, du polypropylène, du polyuréthane, du polyamide, du polyvinylbutyral et de l'éthylène-vinyl acétate.

## Claims

1. A process for producing a radiation detector including a light sensitive sensor assembly (1, 4), a scintillator (6) converting the radiation into radiation to which the light sensitive sensor is sensitive, the scintillator (6) being fixed to the sensor assembly (1, 4) by bonding, the sensor assembly including a substrate (4) and several sensors (1) butted together, the sensors (1) each including two opposing surfaces (11, 12), the first (11) of which is bonded to the substrate (4) and the second (12) of which is bonded to the scintillator (6), **characterised in that** the following operations are performed in order:
- depositing the second surface (12) of the sensors (1) onto an adhesive film (13);
- bonding the first surface (11) of the sensors (1) to the substrate (4);
- bonding the scintillator (6) by means of the adhesive film (13);
and **in that** the adhesive film (13) is used as a reference plane when the sensors (1) are bonded to said adhesive film.

2. The process according to claim 1, **characterised in that** the operation of bonding the sensors (1) to the substrate (4) includes the following operations:
- depositing an adhesive fluid (16) onto the first surface (11) of the sensors (1) and into the gaps (15) separating the sensors (1);
- bonding the sensors (1) and the substrate (4) by means of the adhesive fluid (16).

3. The process according to claim 2, **characterised in that** before depositing the adhesive fluid (16) a ring (20) is placed on the periphery of the sensors (1) to retain said adhesive fluid (16).

4. The process according to claim 1, **characterised in that** the operation of bonding the sensors (1) to the substrate (4) includes the following operations:
- depositing a second adhesive film (25) onto the first surface (11) of the sensors;
- bonding the sensors (1) and the substrate (4) by means of the second adhesive film (25).

5. The process according to claim 4, **characterised in that** the gaps (15) separating the sensors (1) are filled by means of an adhesive fluid.

6. The process according to any one of the previous claims, **characterised in that** the light sensitive sensors (1) include a matrix of TFT type photodiodes or phototransistors made on a plate of amorphous silicon.

7. The process according to any one of the previous claims, **characterised in that** the sensors (1) are made using CMOS technology.

8. The process according to any one of the previous claims, **characterised in that** the scintillator (6) is made from a gadolinium oxide sulphide base.

9. The process according to any one of claims 1 to 7, **characterised in that** the scintillator (6) is made from a cesium iodide base.

10. The process according to any one of the previous claims, **characterised in that** the adhesive film (13, 25) includes a material taken from a group comprising polyethylene, polypropylene, polyurethane, polyamide, polyvinylbutyral and ethylene-vinyl acetate.

## Patentansprüche

1. Verfahren zur Herstellung eines Strahlungsdetektors mit einer lichtempfindlichen Sensoranordnung (1, 4), einem Szintillator (6) zum Umwandeln der Strahlung in eine Strahlung, für die der lichtempfindliche Sensor empfindlich ist, wobei der Szintillator (6) durch Kleben an der Sensoranordnung (1, 4) befestigt wird, wobei die Sensoranordnung ein Substrat (4) und mehrere aneinanderstoßende Sensoren (1) umfasst, wobei die Sensoren (1) jeweils zwei gegenüberliegende Flächen (11, 12) aufweisen, von denen die erste (11) auf das Substrat (4) und die zweite (12) auf den Szintillator (6) geklebt ist, **dadurch gekennzeichnet, dass** die folgenden Operationen in Folge durchgeführt werden:
- Legen der Sensoren (1) mit ihrer zweiten Fläche (12) auf einen Klebfilm (13);
- Kleben der Sensoren (1) mit ihrer ersten Fläche (11) auf das Substrat (4);
- Kleben des Szintillators (6) mit dem Klebfilm (13);
und **dadurch**, dass der Klebfilm (13) als Bezugsebene verwendet wird, wenn die Sensoren (1) auf den Klebfilm geklebt werden.

2. Verfahren nach Anspruch 1, **dadurch gekennzeichnet, dass** der Vorgang des Klebens der Sensoren (1) auf das Substrat (4) die folgenden Vorgänge beinhaltet:
- Auftragen einer Klebflüssigkeit (16) auf die erste Fläche (11) der Sensoren (1) und in die Lücken (15) zwischen den Sensoren (1);
- Verkleben der Sensoren (1) und des Substrats (4) mit der Klebflüssigkeit (16).

3. Verfahren nach Anspruch 2, **dadurch gekennzeichnet, dass** vor dem Auftragen der Klebflüssigkeit (16) ein Ring (20), mit dem die Klebflüssigkeit (16) festgehalten werden kann, auf die Peripherie der Sensoren (1) gelegt wird.

4. Verfahren nach Anspruch 1, **dadurch gekennzeichnet, dass** der Vorgang des Klebens der Sensoren (1) auf das Substrat (4) die folgenden Vorgänge beinhaltet:
- Aufbringen eines zweiten Klebfilms (25) auf die erste Fläche (11) der Sensoren;
- Verkleben der Sensoren (1) und des Substrats (4) mit dem zweiten Klebfilm (25).

5. Verfahren nach Anspruch 4, **dadurch gekennzeichnet, dass** die Lücken (15) zwischen den Sensoren (1) mit einer Klebflüssigkeit gefüllt werden.

6. Verfahren nach einem der vorherigen Ansprüche, **dadurch gekennzeichnet, dass** die lichtempfindlichen Sensoren (1) eine Matrix von auf einer amorphen Siliciumplatte hergestellten Fotodioden oder Fototransistoren des TFT-Typs umfassen.

7. Verfahren nach einem der vorherigen Ansprüche, **dadurch gekennzeichnet, dass** die Sensoren (1) mit einer CMOS-Technik hergestellt werden.

8. Verfahren nach einem der vorherigen Ansprüche, **dadurch gekennzeichnet, dass** der Szintillator (6) auf der Basis von Gadoliniumoxidsulfid hergestellt ist.

9. Verfahren nach einem der Ansprüche 1 bis 7, **dadurch gekennzeichnet, dass** der Szintillator (6) auf der Basis von Cäsiumiodid hergestellt ist.

10. Verfahren nach einem der vorherigen Ansprüche, **dadurch gekennzeichnet, dass** der Klebfilm (13, 25) ein Material beinhaltet, das in einer Gruppe bestehend aus Polyethylen, Polypropylen, Polyurethan, Polyamid, Polyvinylbutyral und Ethylenvinylacetat enthalten ist.
